# EUROPÄISCHE PATENTSCHRIFT

(11) **EP 1 393 436 B1**
(45) Veröffentlichungstag und Bekanntmachung des Hinweises auf die Patenterteilung: **12.10.2005**
(21) Anmeldenummer: 02742743.4
(22) Anmeldetag: 10.05.2002
(51) Int. Cl.: H03B 21/02

(54) **SCHALTUNGSANORDNUNG ZUR FREQUENZUMSETZUNG EINER OSZILLATORFREQUENZ IN EINE TRÄGERFREQUENZ**
CIRCUIT ARRANGEMENT FOR TRANSLATING AN OSCILLATOR FREQUENCY INTO A CARRIER FREQUENCY
ENSEMBLE CIRCUIT PERMETTANT DE CONVERTIR UNE FREQUENCE OSCILLATOIRE EN UNE FREQUENCE PORTEUSE

(30) Priorität: 11.05.2001 DE 10122919
(43) Veröffentlichungstag der Anmeldung: 03.03.2004
(73) Patentinhaber: Infineon Technologies AG, 81669 München (DE)
(72) Erfinder: GREWING, Christian, 40489 Düsseldorf (DE); HANKE, Andre, 40489 Düsseldorf (DE); VAN WAASEN, Stefan, 47178 Duisburg (DE)
(74) Vertreter: Epping - Hermann - Fischer
(86) Internationale Anmeldenummer: PCT/DE2002/001698
(87) Internationale Veröffentlichungsnummer: WO 2002/093731

(56) Entgegenhaltungen:
- WO-A-01/01562
- DE-A- 2 523 131
- US-A- 5 179 359

## Beschreibung

Die vorliegende Erfindung betrifft eine Schaltungsanordnung zur Frequenzumsetzung einer Oszillatorfrequenz in eine Trägerfrequenz.

Zur drahtlosen Datenübermittlung, wie beispielsweise bei dem sogenannten Bluetooth-Konzept, sind zum Senden und Empfangen modulierter Signale üblicherweise Transceiver (Sender-Empfänger) vorgesehen. Zum Herauf- beziehungsweise Heruntermischen eines von einem Lokaloszillator bereitgestellten Signals mit einer Oszillatorfrequenz in ein Trägersignal mit einer Trägerfrequenz ist bei modernen Sendekonzepten darauf zu achten, daß die Oszillatorfrequenz keine höhere Harmonische der sendeseitigen Trägerfrequenz ist. Andernfalls käme es zu unerwünschten Störungen des beispielsweise spannungsgesteuerten Oszillators aufgrund von Rückkopplungseffekten.

Es ist beispielsweise denkbar, einem Frequenzmischer ein Signal mit einer Oszillatorfrequenz an einem Eingang mit halber und an einem weiteren Eingang mit einem Viertel der Oszillatorfrequenz zuzuführen. Demnach stellt der Mischer an seinem Ausgang ein Signal mit 3/4 der ursprünglichen Oszillatorfrequenz bereit. Außerdem fällt die unerwünschte Spiegelfrequenz am Mischerausgang an, welche dadurch unterdrückt werden kann, daß der Mischer als Spiegelunterdrückender Mischer, als sogenannter Image-Reject(IR)-Mixer ausgeführt ist. Die Eingangssignale des Mischers müssen dabei als komplexe IQ-Signale geführt werden. Dies bedeutet jedoch einen hohen schaltungstechnischen Aufwand und ist mit einem verhältnismäßig großen Chipflächenbedarf verbunden. Zudem ist die Qualität der Spiegelunterdrückung im IR-Mischer stark von Fertigungstoleranzen bei der Chipherstellung abhängig, so daß ein hoher Aufwand bei der Herstellung oder ein großer Ausschuß bei der Qualitätskontrolle in Kauf zu nehmen sind.

Ein derartiger Gegenstand ist in dem Dokument DE 19928998 A1 angegeben. Dort ist eine Schaltungsanordnung mit einem spiegelfrequenzunterdrückenden Mischer gezeigt, der ein Oszillatorsignal in ein Sendesignal umsetzt. Hierfür wird das Oszillatorsignal dem spiegelfrequenzunterdrückenden Mischer an einem Eingang mit der Oszillatorfrequenz und an einem weiteren Eingang mit heruntergeteilter Frequenz zugeführt.

In dem Dokument WO 01/01562 A1 ist eine elektronische Schaltungsanordnung zur Erzeugung einer Sendefrequenz angegeben. Dabei ist eine Mischstufe mit nachfolgendem Bandfilter vorgesehen, der eine Oszillatorfrequenz und eine durch den Faktor N geteilte Oszillatorfrequenz als Eingangssignale zugeführt werden.

Bei den beschriebenen, modernen Mobilfunkkonzepten ist es wünschenswert, Sende- und Empfangsschaltungen mit besonders geringer Chipfläche, geringer Stromaufnahme sowie weitgehender Unabhängigkeit der Schaltung von Produktionstoleranzen zu ermöglichen.

Es ist daher bei der Bereitstellung der Trägerfrequenz, der sogenannten Transmitfrequenz, auf eine Unterdrückung unerwünschter Signale und Frequenzkomponenten zu achten und dabei mit geringer Chipfläche und geringem Strombedarf auszukommen.

Aufgabe der vorliegenden Erfindung ist es, eine Schaltungsanordnung zur Frequenzumsetzung einer Oszillatorfrequenz in eine Trägerfrequenz anzugeben, welche mit geringer Chipfläche auskommt, eine geringe Stromaufnahme aufweist sowie einen einfachen Aufbau hat.

Erfindungsgemäß wird die Aufgabe gelöst von einer Schaltungsanordnung zur Frequenzumsetzung einer Oszillatorfrequenz in eine Trägerfrequenz, aufweisend die Merkmale des Patentanspruchs 1.

Der Frequenzmischer bei vorliegender Schaltungsanordnung mischt ein vom ersten Signalpfad bereitgestelltes frequenzmäßig unverändert übertragenes Oszillatorsignal mit einem frequenzmäßig heruntergeteilten, ebenfalls vom Oszillatorsignal abgeleiteten Signal.

Dabei ist der erste Eingang des Mischers, dem das Signal mit der Oszillatorfrequenz unverändert zugeführt wird, bevorzugt der schaltend arbeitende Lokaloszillator-Eingang des Mischers und der zweite Eingang des Mischers, dem das Signal mit der Oszillatorfrequenz frequenzmäßig herunter geteilt zugeführt wird, ist bevorzugt ein linearer Signaleingang des Mischers.

Der Mischer stellt an seinem Ausgang zum einen ein Signal mit der Differenzfrequenz der beiden Eingangsfrequenzen und zum anderen ein Signal mit der Summenfrequenz der beiden Differenzfrequenzen, das sogenannte Spiegelsignal, bereit. Mit einem Tiefpaßfilter ist es in einfacher Weise möglich, die tiefer liegende Nutzsignalfrequenz von der Spiegelfrequenz zu trennen. Bei den für Bluetooth üblicherweise verwendeten Übertragungsfrequenzen von einigen Gigahertz genügt hierfür ein herkömmlicher Bufferverstärker am Ausgang des Mischers, welcher üblicherweise zur Signalverstärkung ohnehin vorhanden ist, um die frequenzmäßig höherliegende Spiegelfrequenz zu unterdrücken.

Der Mischer selbst muß demnach nicht mehr selbst als Imagereject-Mischer beziehungsweise als spiegelunterdrückender Mischer ausgebildet sein, kann deshalb mit geringer Chipfläche aufgebaut sein und weist einen geringen Strombedarf auf. Zudem ist die Spiegelfrequenzunterdrückung unabhängig von der Phasenlage der Inphase- und Quadratur-Komponenten der Frequenzanteile der vom ersten und zweiten Signalpfad übertragenen Signale, welche durch Produktions- und Fertigungsstreuungen schwanken können. Der hierdurch mögliche Verzicht auf das Führen der Eingangssignale des Mischers als IQ-Signale ermöglicht eine weitere, deutliche Chipflächenreduzierung.

Gemäß der vorliegenden Erfindung ist der Frequenzteiler ein Dividiert-Durch-Vier-Teiler und ausgelegt zum Bereitstellen eines Ausgangssignals mit einem Viertel der Frequenz des an seinem Eingang anliegenden Oszillatorsignals.

Ein Dividiert-Durch-Vier-Frequenzteiler ist mit besonders geringer Chipfläche und besonders einfachem Aufbau realisierbar. In diesem Fall stellt der Mischer an seinem Ausgang zum einen ein Signal mit drei Viertel der Oszillatorfrequenz sowie ein Spiegelsignal mit fünf Viertel der Oszillatorfrequenz bereit. Demnach ist die Oszillatorfrequenz keine höhere Harmonische der Trägerfrequenz, so daß keine Störungen des Oszillators durch Rückkopplungen entstehen.

Am Zahlenbeispiel für Bluetooth bedeutet dies, daß der Lokaloszillator, beispielsweise ein spannungsgesteuerter Oszillator, eine Oszillatorfrequenz von 3,2 GHz aufweist. Dem Mischer wird zum einen die Oszillatorfrequenz von 3,2 GHz an seinem ersten Eingang und zum anderen an seinem zweiten Eingang die frequenzmäßig heruntergeteilte Oszillatorfrequenz von 800 MHz bereitgestellt, die sich aus Division von 3,2 GHz durch 4 ergibt. Am Ausgang des Mischers steht demnach ein Signal bereit, welches zum einen die gewünschte Trägerfrequenz für Bluetooth von 2,4 GHz aufweist und zum anderen eine Spiegelfrequenz von 4 GHz liefert. Für Frequenzen im Bereich von 4 GHz wirken jedoch derzeit übliche Bufferverstärker, wie sie am Ausgang von Aufwärtsmischern in Sendeempfängern im Mobilfunk eingesetzt werden, bereits als Dämpfer mit ausreichender Tiefpaßwirkung, so daß die Spiegelfrequenz wirksam unterdrückt wird.

In einer weiteren, bevorzugten Ausführungsform der vorliegenden Erfindung umfaßt der Frequenzteiler zwei als Flipflop ausgebildete, hintereinandergeschaltete Dividiert-Durch-Zwei-Teiler. Zur Frequenzteilung im Hochfrequenzbereich einsetzbare Flipflops haben üblicherweise zwei Ausgänge, welche zueinander eine Phasenverschiebung von 90° aufweisen. Bei vorliegender Anordnung muß das ausgangsseitig am Flipflop anliegende Signal jedoch nicht als IQ-Signal weitergeführt werden, wie bereits erläutert.

In einer weiteren, bevorzugten Ausführungsform der vorliegenden Erfindung weist der zweite Signalpfad ein Tiefpaßfilter auf, welches dem Frequenzteiler nachgeschaltet ist. Durch die Frequenzteilung im Frequenzteiler entstehen üblicherweise höhere Harmonische, welche durch geeignete Dimensionierung des Tiefpaßfilters und geeignetem Einstellen von dessen Grenzfrequenz herausgefiltert werden, so daß am Eingang des Mischers, bevorzugt an dessen Signaleingang, lediglich das Signal mit der durch 4 geteilten Lokaloszillatorfrequenz bereitsteht.

In einer weiteren, bevorzugten Ausführungsform der vorliegenden Erfindung ist ein Verstärker zum Unterdrücken der Spiegelfrequenz, welche sich durch Addieren der beiden eingangsseitig anliegenden Frequenzen ergibt, angeschlossen. Anstelle des Verstärkers, bevorzugt eines Bufferverstärkers, könnte auch ein geeignet dimensioniertes Tiefpaßfilter explizit vorgesehen sein. Diese Tiefpaßfilterung am Ausgang des Mischers bewirkt eine ausreichende Dämpfung der Spiegelfrequenz vor der Weiterverarbeitung in nachfolgenden Stufen der Schaltung und ermöglicht insbesondere den Verzicht auf eine aufwendige und Ausführung des Frequenzmischers als spiegelfrequenzunterdrückender Mischer.

In einer weiteren, bevorzugten Ausführungsform der vorliegenden Erfindung ist zur Bereitstellung der Oszillatorfrequenz ein Oszillator vorgesehen, der mit dem Schaltungsknoten gekoppelt ist. Der Oszillator, der bevorzugt als spannungsgesteuerter Oszillator ausgebildet ist, stellt dabei an seinem Ausgang eine Oszillatorfrequenz zur Verfügung, welche gleich dem 4/3-fachen der Trägerfrequenz, welche gewünscht ist, betragen muß, um bei dem Spezialfall der Frequenzteilung durch vier im zweiten Signalpfad am Ausgang des Mischers gerade die Trägerfrequenz beziehungsweise die Transmit-Frequenz zu erhalten.

Weitere Einzelheiten der Erfindung sind Gegenstand der Unteransprüche.

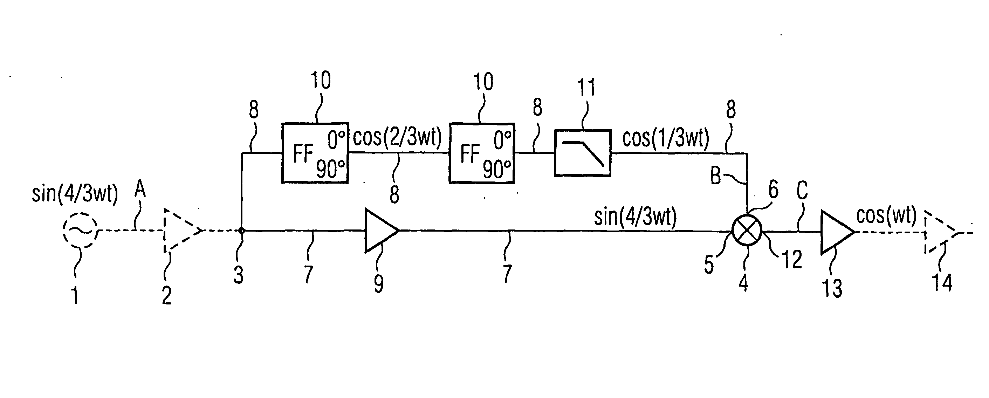

Die Erfindung wird nachfolgend an einem Ausführungsbeispiel anhand der Figur näher erläutert.

Es zeigt:

Die Figur ein vereinfachtes Blockschaltbild einer ersten Ausführungsform der vorliegenden Schaltungsanordnung.

Die Figur zeigt eine Schaltungsanordnung zur Frequenzumsetzung einer Oszillatorfrequenz in eine Trägerfrequenz. Diese umfaßt einen spannungsgesteuerten Oszillator 1, der über einen Signalverstärker 2 an einen Schaltungsknoten 3 angeschlossen ist. Ein Aufwärtsmischer 4 mit einem ersten, als Lokaloszillator ausgebildeten Eingang 5 und einem zweiten, als linearem Signaleingang 6 ausgebildeten Eingang ist über je einen Signalpfad 7, 8 mit dem Schaltungsknoten 3 gekoppelt. Ein erster Signalpfad 7 ist so ausgebildet, daß das vom spannungsgesteuerten Oszillator 1 bereitgestellte Signal mit der Oszillatorfrequenz A frequenzmäßig unverändert am ersten Eingang 5 des Mischers 4 bereit steht. Das Signal mit der Oszillatorfrequenz A ist im vorliegenden Ausführungsbeispiel ein sinusförmiges Signal der Kreisfrequenz 4/3ω, mit ω = Kreisfrequenz der gewünschten Trägerfrequenz. Der erste Signalpfad 7 umfaßt einen Signalverstärker 9. Ein zweiter Signalpfad 8 verbindet ebenfalls den Schaltungsknoten 3 mit dem Mischer 4 und ist hierfür an dessen zweiten Eingang 6, der als linearer Signaleingang ausgebildet ist, angeschlossen. Der zweite Signalpfad 8 umfaßt eine Serienschaltung aus zwei :2- Frequenzteilern 10 sowie ein Tiefpaßfilter 11 zum Herausfiltern von durch die Frequenzteilung 10 verursachten höheren Harmonischen der Oszillatorfrequenz. Die :2-Teiler 10 stellen an ihrem Ausgang jeweils ein Signal mit der halben Eingangssignalfrequenz bereit. Demnach steht am Eingang 6 des Mischers 4 ein Signal B mit einem Viertel der Frequenz des Signals mit der Oszillatorfrequenz A bereit. Dieses ist im vorliegenden Ausführungsbeispiel ein Cosinus-Signal mit einem Drittel der Kreisfrequenz ω des Trägersignals.

Der Frequenzmischer 4 stellt an seinem Ausgang 12 ein Signal bereit, welches zum einen Frequenzanteile umfaßt, die sich aus der Differenz der Frequenzen der Eingangssignale A, B ergeben und zum anderen Spiegel-Frequenzanteile umfaßt, die sich aus der Summe der Frequenzanteile der Eingangssignale A, B ergeben. Das Signal mit der Trägerfrequenz C am Ausgang 12 des Mischers 4 umfaßt demnach Kreisfrequenzanteile der Kreisfrequenz ω sowie 5/3ω. Letztere Frequenzanteile sind dabei Spiegelfrequenzen des gewünschten Trägers mit der Frequenz ω. Der Mischer 4 ist nicht als spiegelfrequenzunterdrückender Mischer ausgebildet. Vielmehr werden die unerwünschten Spiegelfrequenzanteile in einem am Ausgang 12 des Mischers 4 angeschlossenen Bufferverstärker 13 wirksam unterdrückt. Zur besseren Dämpfung der Spiegelfrequenz kann dem Buffer 13 ein weiterer Verstärker 14 nachgeschaltet sein. Die Signalpfade 7, 8 sind in vorliegender Ausführung nicht als IQ-Signalpfade zur Führung komplexer Signale ausgelegt.

Gegenüber einer Ausführung mit spiegelfrequenzunterdrückender Mischung zur Bereitstellung einer Trägerfrequenz abgeleitet aus einer Oszillatorfrequenz, beispielsweise mit einer Frequenzteilung durch zwei im ersten Signalpfad und einer Frequenzteilung durch vier im zweiten Signalpfad, hat die beschriebene Schaltungsanordnung den Vorteil, daß eine deutliche Reduzierung der Stromaufnahme des Sendepfades in einen Transceiver, der beispielsweise im Mobilfunk einsetzbar ist, von circa 40% erzielbar ist. Zugleich ist die beschriebene Schaltungsanordnung auf der halben Chipfläche bezogen auf obige Ausführung integrierbar. Zudem ist die beschriebene Spiegelfrequenzunterdrückung bezüglich ihrer Performance deutlich geringeren Fertigungstoleranzen unterworfen. Auch die Ausgangsleistung der beschriebenen Schaltungsanordnung ist weitgehend unabhängig von Fertigungstoleranzen. Die Unterdrückung der Spiegelfrequenz ist bei vorliegender Ausführung nicht von den Phasenlagen von IQ-Komponenten abhängig.

Da die vorliegende Schaltungsanordnung die Verwendung eines Toggle-Flipflops zum Erzeugen eines IQ-Signals beim Herunterteilen der Oszillatorfrequenz vermeidet, sind höhere Grenzfrequenzen im Sendepfad eines Mobilfunk-Transceivers erreichbar.

Anstelle der ausgangsseitig am Mischer 4 vorgesehenen Verstärker 13, 14 kann zur Unterdrückung der Spiegelfrequenz auch ein Tiefpaßfilter vorgesehen sein.

### Bezugszeichenliste

- 1: Oszillator
- 2: Verstärker
- 3: Schaltungsknoten
- 4: Mischer
- 5: LO-Eingang
- 6: Signaleingang
- 7: Signalpfad
- 8: Signalpfad
- 9: Verstärker
- 10: Flipflop
- 11: Flipflop
- 12: Ausgang
- 13: Buffer
- 14: Verstärker

## Patentansprüche

1. Schaltungsanordnung zur Frequenzumsetzung einer Oszillatorfrequenz (A) in eine Trägerfrequenz (C), aufweisend
- einen Schaltungsknoten (3), dem ein Signal mit der Oszillatorfrequenz (A) zuführbar ist,
- einen Mischer (4) mit einem ersten Eingang (5), einem zweiten Eingang (6) und mit einem Ausgang (12),
- einen ersten Signalpfad (7) zur Kopplung von Schaltungsknoten (3) und erstem Eingang des Mischers (5) zum frequenzmäßig unveränderten Übertragen des Signals mit der Oszillatorfrequenz (A), und
- einen zweiten Signalpfad (8) mit einem Frequenzteiler (10), der eingangsseitig mit dem Schaltungsknoten (3) und ausgangsseitig mit dem zweiten Mischereingang (6) gekoppelt ist, wobei
- der Frequenzteiler (10) ausgelegt ist zum Bereitstellen eines Ausgangssignal mit einem Viertel der Frequenz (B) des an seinem Eingang anliegenden Oszillatorsignals (A), wobei
- der zweite Signalpfad (8) ein Tiefpaßfilter (11) aufweist, welches dem Frequenzteiler (10) nachgeschaltet ist.

2. Schaltungsanordnung nach Anspruch 1,
**dadurch gekennzeichnet, daß**
der Frequenzteiler (10) zwei als Flipflop ausgebildete, hintereinandergeschaltete Teiler (10) umfaßt, welche jeweils an ihrem Ausgang ein Signal mit der halben Frequenz des an ihrem Eingang anliegenden Signals bereitstellen.

3. Schaltungsanordnung nach einem der Ansprüche 1 oder 2,
**dadurch gekennzeichnet, daß**
ein Verstärker (13) zum Unterdrücken einer höheren Mischfrequenz, welche sich durch Addition der Frequenzen der am Eingang des Mischers (4) anliegenden Signale (A, B) ergibt, an den Ausgang (12) des Mischers (4) angeschlossen ist.

4. Schaltungsanordnung nach einem der Ansprüche 1 bis 3,
**dadurch gekennzeichnet, daß**
zur Bereitstellung der Oszillatorfrequenz (A) ein Oszillator (1) vorgesehen ist, der mit dem Schaltungsknoten (3) gekoppelt ist.

## Claims

1. Circuit arrangement for the frequency conversion of an oscillator frequency (A) into a carrier frequency (C), having
- a circuit node (3), to which a signal with the oscillator frequency (A) can be fed,
- a mixer (4) with a first input (5), a second input (6) and with an output (12),
- a first signal path (7) for coupling the circuit node (3) and the first input of the mixer (5) for the transmission of the signal with the oscillator frequency (A) unchanged in its frequency, and
- a second signal path (8) with a frequency divider (10), which is coupled on the input side to the circuit node (3) and is coupled on the output side to the second mixer input (6),
- the frequency divider (10) being designed for providing an output signal with a quarter of the frequency (B) of the oscillator signal (A) present at its input,
- the second signal path (8) has a low-pass filter (11), which is arranged downstream of the frequency divider (10).

2. Circuit arrangement according to Claim 1, **characterized in that** the frequency divider (10) comprises two dividers (10) which are formed as flip-flops, are arranged one behind the other and respectively provide at their output a signal with half the frequency of the signal present at their input.

3. Circuit arrangement according to one of Claims 1 or 2, **characterized in that** an amplifier (13) for rejecting a higher mixing frequency, which is obtained by addition of the frequencies of the signals (A, B) present at the input of the mixer (4), is connected to the output (12) of the mixer (4).

4. Circuit arrangement according to one of Claims 1 to 3, **characterized in that** an oscillator (1) which is coupled to the circuit node (3) is provided for providing the oscillator frequency (A).

## Revendications

1. Montage de conversion d'une fréquence (A) d'oscillateur en une fréquence (C) de porteuse comprenant
- un noeud (3) de circuit auquel peut être envoyé un signal ayant la fréquence (A) de l'oscillatéur ;
- un mélangeur (4) ayant une première entrée (5), une deuxième entrée (6) et une sortie (12) ;
- un premier trajet (7) de signal pour le couplage du noeud (3) de circuit et de la première entrée du mélangeur (5) pour la transmission non modifiée en fréquence du signal ayant la fréquence (A) de l'oscillateur ; et
- un deuxième trajet (8) du signal ayant un diviseur (10) de fréquence qui est couplé du côté entrée au noeud (3) du circuit et du côté sortie à la deuxième entrée (6) du mélangeur, dans lequel
- le diviseur (10) de fréquence est conçu pour procurer un signal de sortie ayant un quart de la fréquence (B) du signal (A) d'oscillateur s'appliquant à son entrée, dans lequel
- le deuxième trajet (8) du signal comporte un filtre (11) passe-bas qui est monté en aval du diviseur (10) de fréquence.

2. Montage suivant la revendication 1,
**caractérisé en ce que** le diviseur (10) de fréquence comprend deux diviseurs (10) constitués en bascule et montés en série qui procurent respectivement sur leur sortie un signal ayant la moitié de la fréquence du signal s'appliquant à leur entrée.

3. Montage suivant l'une des revendications 1 ou 2,
**caractérisé en ce qu'**un amplificateur (13) de suppression d'une fréquence mixte assez haute, qui provient de l'addition des fréquences des signaux (A, B) s'appliquant à l'entrée du mélangeur (4), est raccordé à la sortie (12) du mélangeur (4).

4. Montage suivant l'une des revendications 1 à 3,
**caractérisé en ce que**, pour procurer la fréquence (A) d'oscillateur, il est prévu un oscillateur (1) qui est couplé au noeud (3) de circuit.
